(19) Europäisches Patentamt
European Patent Office
Office européen des brevets

(11) EP 0 698 282 B1

# (12) EUROPEAN PATENT SPECIFICATION

(45) Date of publication and mention of the grant of the patent: **06.09.2000 Bulletin 2000/36**

(21) Application number: **94916954.4**

(22) Date of filing: **10.05.1994**

(51) Int. Cl.[7]: **H01L 21/311**, H01L 21/306

(86) International application number: **PCT/EP94/01534**

(87) International publication number: **WO 94/27315 (24.11.1994 Gazette 1994/26)**

(54) **Method for etching silicon oxide layers using mixtures of HF and carboxylic acid**

Verfahren zum Ätzen Silizium-Oxid-Schichten mit Mischungen von HF und Carbonsäure

Procédé d'attaque de couches d'oxyde de silicium a l'aide de mélanges de HF et d'acide carboxylique

(84) Designated Contracting States: **AT BE CH DE DK ES FR GB IE IT LI NL SE**

(30) Priority: **13.05.1993 EP 93870080**

(43) Date of publication of application: **28.02.1996 Bulletin 1996/09**

(60) Divisional application: **99204576.5**

(73) Proprietors:
- **INTERUNIVERSITAIR MICRO-ELEKTRONICA CENTRUM VZW 3001 Heverlee (BE)**
- **ADVANCED SEMICONDUCTOR MATERIALS, Naamloze Vennotschap NL-3723 BS Bilthoven (NL)**

(72) Inventors:
- **VERHAVERBEKE, Steven B-1040 Schaarbeek (BE)**
- **GEUSENS, Walda B-3360 Korbeek-Lo (BE)**
- **BELLEMANS, Marc B-3071 Erps-Kwerps (BE)**
- **DULST, Marc B-1150 Sint-Pieters-Woluwe (BE)**
- **HEYNS, Marc B-3210 Linden (BE)**
- **de BLANK, R. NL-3815 TL Amersfoort (NL)**
- **HENDRIKS, M. NL-3761 XK Soest (NL)**
- **KWAKMAN, L., F., Tz. NL-3704 MV Zeist (NL)**
- **GRANNEMAN, E., H., A. NL-1217 AD Hilversum (NL)**

(74) Representative: **Van Malderen, Joelle et al Office Van Malderen, Place Reine Fabiola 6/1 1083 Bruxelles (BE)**

(56) References cited:
**EP-A- 0 488 198**
**EP-A- 0 536 747**
**EP-A- 0 536 752**
**DE-B- 1 302 175**
**US-A- 5 022 961**

- **JOURNAL OF THE ELECTROCHEMICAL SOCIETY, vol.138, no.6, June 1991, MANCHESTER, NEW HAMPSHIRE US pages 1799 - 1802 WONG ET AL 'characterization of wafer cleaning and oxide etching using vapor phase hydrogen fluoride'**
- **'Condensed chemical dictionary', 1961, 6TH EDITION,REINHOLD PUBLISHING CORPORATION, NEW YORK see page 345**
- **ILER, R.K. 'The colloid chemistry of silica and silicates', 1995, CORNELL UNIVERSITY PRESS, NEW YORK see page 252 - page 255**

Remarks:
The file contains technical information submitted after the application was filed and not included in this specification

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 0 698 282 B1

Printed by Xerox (UK) Business Services
2.16.7 (HRS)/3.6

## Description

### Objects of the present invention

The present invention is related to improvements in semiconductor processing using HF formulated mixtures. The invention is more specifically related to methods making use of these mixtures in gas phase etching techniques of oxide layers, especially etching $SiO_2$ layers and in the so-called last step in the cleaning process.

### State of the art and background of the invention

In the semiconductor processing, liquid HF mixtures are often used for etching thick $SiO_2$ layers or for etching chemical or native oxide layers.
For etching thick $SiO_2$ layers, usually buffered HF is used, which is a mixture of $NH_4F$ and HF, in the liquid phase, generally as a solution in water.
Moreover, as a last step in the cleaning process, usually a diluted HF step is used.
Etching of bare silicon wafers in HF solution and/or a final etch in HF solution generally in combination with the RCA-process have been the object of many experimentation and publications.
The RCA-cleaning process for bare or oxidized silicon wafers is based on a two-step oxidizing and complexing treatment with hydrogen peroxide solutions: an alkaline mixture at high pH and followed by an acidic mixture at low pH (W. Kern and D. Puotinen, "Cleaning Solutions Based on Hydrogen Peroxide for Use in Silicon Semiconductor Technology", RCA Review, 31, 187-206 (1970)).
"HF-last cleaning" result in a Si-surface free of silicon oxide and passivated with hydrogen. However, the execution of this process with liquid HF mixtures is very susceptible to contamination.
The etch bath, chemicals, rinsing water and air ambient need to be very clean to achieve good results. Otherwise, severe contamination of the wafers with particles, metals and organic material can occur during the etching rinsing or drying process. "HF-last" processing with liquid mixtures before gate oxidation is, therefore, still a point of controversy.
As an alternative, the etching can be performed with HF mixtures in the vapour phase to prevent recontamination from the liquid and during rinsing and drying of the wafers. By etching in the gas phase, recontamination from the liquid is omitted and the high susceptibility of the wafer for contamination during the drying stage is avoided. Furthermore, in the gas phase the etching of small features is facilitated while surface tension effects hamper this in the liquid phase.
Traditionally, the HF vapour etching is performed with a mixture of HF and $H_2O$ vapours. This is described in US-A-4,749,440 of FSI for processes performed at near atmospheric pressures in a mode where the process gases are continuous flowing, the so-called dynamic mode. Because of controllability problems with this process, the process was improved by performing it at substantially reduced pressures (600 Pa-2000 Pa) and applying a different procedure, the so-called static mode (see also US-A-5,167,761). Despite of these improvements, the controllability of the process is still problematic.
As an alternative, a method for etching silicon oxide by feeding anhydrous HF and alcohol vapour simultaneously into a reaction chamber is described in US-A-5,022,961. However, this process suffers from the same limitations as the HF/water vapour process.
It is to be noted that gas phase processing steps are also used for other applications than silicon oxide etching in semiconductor processing. Document EP-A-0536752 discloses a vapor-phase process for cleaning metal-containing contaminants from the surfaces of integrated circuits and semiconductors between the numerous fabricating steps required to manufacture the finished electronic devices. The process comprises contacting the surface with an effective amount of a cleaning agent comprising a carboxylic acid selected from formic acid or acetic acid at a temperature sufficient to form volatile metal ligand complexes on the surface of the substrate to be cleaned. The volatile metal ligand complexes are then sublimated from the surface of the substrate providing a clean substantially residue-free substrate.
Document EP-A-0536752 discloses more particularly a mixture of carboxylic acid for achieving this process. This document describes a general embodiment wherein the substrate to be cleaned is placed in a heated chamber, wherein the substrate is then heated to a desired temperature typically from about 100° to 400°C. The desired cleaning agent is delivered to the electronic device to be cleaned by heating the cleaning agent to a temperature sufficient to create a sufficient operating vapor pressure. In a specific example, the use of a mixture of formic acid and air gas at 200°C is mentioned for the stated cleaning purpose.
As an alternative embodiment, an effective amount of this cleaning agent is dispersed in an inert atmosphere including nitrogen, argon or helium. In another embodiment, an effective amount of the cleaning agent is dispersed in an oxidizing atmosphere wherein the combination of the carboxylic acid and oxidizing atmosphere is capable

of oxidizing the metal- containing contaminants residing on the surfaces of the substrate to their corresponding metal oxides, which thereafter, are capable of reacting with the enumerated cleaning agents to form volatile metal-ligand complexes.

**Aims of the present invention**

The main aims of the present invention are to provide a method for etching silicon oxide layers with HF formulated mixtures operating in the gas phase which are more reliable than previous mixtures and which have an etching behavior which is very reproducible, which achieve good electrical results with respect to the oxides grown on oxide stripped silicon surfaces and which provide a reproducible and uniform process for etching of thick oxide layers. According to the invention there is provided a method as defined in the appended claims.

Other objects and advantages of the present invention will appear to those skilled in the art from the detailed description of the invention to follow.

**Main characteristic features of the invention**

In order to achieve the intended aims, especially for semiconductor processing, the present invention proposes the use in the gaseous phase of mixtures of hydrogen fluoride and one or more carboxylic acids, possibly in admixture with water vapor, gases such as Ar, $N_2$, $H_2$, HCl or organic solvents such as alcohols, ketones, aldehides and esters.

The carboxylic acid which is used is generally acetic acid (HAc). However, other carboxylic acids having one or more carboxylic functional groups (-COOH) may be used.

The pressures of HF and carboxylic acid in the gas phase may vary between 1 Pa and $10^4$ Pa. The specific partial pressures of respectively the HF vapour and the carboxylic acid vapour are 300 Pa and 600 Pa in etching techniques of $SiO_2$ and last step cleaning operations. Water can be added to enhance the etch rate or influence the selectivity of the etch rate for different types of oxides. When water vapour is present, the partial pressure of water may vary between 1 Pa and $10^4$ Pa.

**Brief description of the drawings**

In order to illustrate the state of the art and the advantages of the present invention, the following descriptions are to be read in conjunction with the accompanying drawings.

In these drawings:

- Figure 1 is a diagram of the etch depth as a function of the etching time in HF/$H_2O$ vapours.
- Figure 2 is a liquid/vapour phase diagram of HAc/$H_2O$ mixtures.
- Figure 3 is a diagram of the etch depth as a function of the etching time in HF/HAc vapours.
- Figure 4 is the interpretation of empirical model graphs.

**Detailed description of an embodiment of the state of the art**

Traditionally, the HF vapour etching is performed with a mixture of HF and $H_2O$ vapours.

HF vapour can be generated by feeding a carrier gas like $N_2$ through a container with a mixture of liquid HF/$H_2O$. Alternatively, a bottle with anhydrous HF can be used as the source for HF vapour. In the latter case, it is found that anhydrous HF alone hardly etches $SiO_2$ at room temperature. The presence of $H_2O$ is therefore preferred to initiate the reaction according to the overall equation:

$$SiO_2 + 4HF \xrightarrow{(H_2O)} SiF_4 + 2H_2O$$

The process can be performed in the static mode and in the dynamic mode.

In the static mode, the reactor is filled with a process gas up to a certain pressure and then the reactor is isolated for some time. Subsequently, the reactor is evacuated and the etch cycle can be repeated for a number of times. In the dynamic mode, a continuous flow of process gas is fed into the reactor which is maintained at a constant pressure.

However, it is generally recognized that it is difficult to control the etching reaction of $SiO_2$ with gaseous HF/water mixtures and to apply the etching process with good repeatability. The reproducibility can be seen from etching experiments as a function of time. If the reproducibility is good, then all experiments should follow a smooth evolution with time. In figure 1, the etch depth in Å is shown as a function of etching time in a mixture of HF and $H_2O$ vapour for one static etch cycle. It is clear from this figure that the reproducibility is poor since the etching processes do not follow a smooth time evolution.

Furthermore, the process is inflicted with an incubation time: under the chosen conditions, the first 10 minutes very limited etching occurs, see figure 1. The incubation time is found to depend on the pretreatment of the wafers. An RCA-cleaning just prior to the HF vapour etching reduces the inhibition time. This is related to the concentration of adsorbed $H_2O$ molecules on the oxide surface.

The onset of the etching process critically depends on the amount of molecules adsorbed on the silicon oxide surface. Water adsorption on the silicon oxide surface in its turn is dependent on the number of OH centers already present on the surface and in this way is dependent on the quality of the oxide.

Uniform etching is another important criterion that determines the usefulness of the process. The uniformity within the wafer and from wafer to wafer for a process using a batch of 6 wafers is represented in table 1. In column 5 of said table 1 the standard deviation within the wafer is shown. As can be seen from these Values, the standard deviation within the wafer is not very good (32%). Also there is quite a standard deviation from the wafer to wafer on the mean etch depth. In the presented case it is 27%. All these values show that the vapour HF/$H_2O$ mixture does etch the $SiO_2$ but has not a good performance regarding reproducibility, within wafer uniformity and wafer to wafer uniformity.

**<u>Detailed description of the preferred embodiments of the invention</u>**

The present invention is based on the consideration that the good reproducibility of the etching operation may be obtained by use in the gas phase of the new mixtures of the present invention comprising carboxylic acid mixed with HF and possibly in admixture with $H_2O$.

Anhydrous HF hardly etches silicon oxide at room temperature. A catalyst is necessary to start the reaction. Although $H_2O$ can fulfil this role, the adsorption of $H_2O$ on the silicon oxide surface is dependent on the number of OH centres already present and in this way on the quality of the oxide. The adsorption of organic molecules shows a strongly reduced sensitivity for the amount of OH groups on the surface. Furthermore, the maximum density of adsorbed molecules strongly depends on the type of molecule. In table 2, the surface area occupied per adsorbed molecule is given for a number of different molecules. Obviously, acetic acid occupies the smallest surface area.

Among the various carboxylic acids, acetic acid is a good choice regarding melting point (17°C), boiling point (118°C) and the shape of the carboxylic acid/$H_2O$ liquid/vapour phase diagram. However, other carboxylic acids having similar properties might be equally good or better choices.

The reaction involves the formation of $SiF_4$ and $H_2O$ which are both gases at the used pressures :

$$SiO_2 + HF \xrightarrow{(HAc)} SiF_4 + 2H_2O$$

The acetic acid only serves as catalyst.

The etching of $SiO_2$ by HF generates water on the wafer surface. This water is, together with the acetic acid and the HF, assumed to be present in the form of a thin liquid film on the surface of the wafer and must be transported away from the wafer surface by evaporation. In this respect the acetic acid/$H_2O$ phase diagram for liquid/vapour equilibria is determining. This phase diagram is shown in figure 2. As shown in the figure, the vapour and liquid curves are close together. This means that the composition of the vapour leaving the surface is close to the composition of the liquid on the surface. The shape of the curve implies that the vapour is even somewhat more water rich than the liquid. Consequently, the water generated on the surface can easily be transported away. For other organic liquids like alcohols, acetone, the liquid and vapour curves are far apart resulting in a large difference between composition of the liquid and the vapour. Furthermore, for the mentioned materials the shape of the curves is such that the vapour is substantially less water rich than the liquid. Hence the water is not easily removed from the surface, giving rise to a strong increase in surface water concentration in the course of the etching process. This results in a fundamental controllability problem of the etching process which is not present with carboxylic acids and especially acetic acid.

Figure 3 illustrates as an example the etching behaviour of a mixture in accordance with the invention. The etch depth as a function of time is shown when $SiO_2$ is etched in an HF/acetic acid gas phase mixture. As can be seen, the reproducibility is very good since the time evolution is very smooth. It must be noted that the processes which were run to generate this graph were run over different days and still the measured etch depths fall on a smooth curve showing the high degree of reproducibility.

Acetic acid appears to have a similar catalytic effect on the HF etch process as $H_2O$ because substantial etch rates are achieved. For the static etch mode, a perfectly proportional relation between etch time and etch depth is

found until for large times the curve flattens out because of depletion effects. No incubation time can be observed.

In table 3, the etching uniformity of this process is examined in the same way as the HF/$H_2O$ vapour mixture. Good uniformity within the wafer (average standard deviation 6.05%) and good uniformity from wafer to wafer (standard deviation 3.5%) is achieved.

This shows that the process HF vapour/carboxylic acid yield much more uniform and reproducible etching than the HF/$H_2O$ process.

The HF/acetic acid parameter space was investigated according to the matrix given in table 4. Modelling the results gave the graphs as presented in figure 4. The influence of acetic acid on the etching process is substantial. The acetic acid partial pressure provides a means to reduce the variation in etch depth over the water and over the batch and improves the controllability of the process.

These results relate to the etching of silicon oxide formed by the thermal oxidation of silicon in dry oxygen or in water vapor. For silicon oxide films formed by chemical vapor deposition the etch rate is typically higher. In table 5 the etch rate selectivity which is the ratio of the etch rate of silicon oxide formed by thermal decomposition of Tetra Ethyl Ortho Silicate (TEOS) and the etch rate of silicon oxide formed by thermal oxidation of silicon is given for two process :

1) a liquid mixture of 0.5 vol % HF in $H_2O$,
2) a vapor mixture of HF and acetic acid according to the present invention.

Densification of the TEOS oxide after deposition substantially reduces the etch rate but the etch rate still remains higher than that of thermal oxide. In general it is to be preferred that the selectivity is close to 1 to allow a controlled removal of different types of oxides that can simultaneously be present. The performance of the HF/acetic acid mixture is in this respect approximately equivalent to the liquid mixture.

Tests for particle contamination showed in the HF/acetic acid vapour etch process an average increase of 46 light point defects (0.12 μm Latex Sphere Equivalent) per 125 mm wafer, which is very low.

The invention will be further elucidated referring to the following example.

<u>**Example**</u>

The method according to the subject invention was realized in a reaction chamber equipped with three inlets: one for anhydrous HF, one for acetic acid and one for a dry $N_2$ purge. The gas lines for HF and acetic acid are heated to approximately 50°C. A metal bottle with anhydrous HF at room temperature is used as source for the HF vapour. Acetic acid is supplied from a quartz bottle which is maintained at 45°C. The flows of the vapours are controlled by Mass Flow Controllers. The inlet lines were combined at a distance of about 50 cm above the reactor. The reactor and associated equipment according to the invention was made from materials chemically resistant to the reactive HF/carboxylic acid/water mixtures. The reactor and some other parts were made of stainless steel and coated with Halar®. The wafer boat and the part of the gas lines that is exposed to the vapour mixtures were made of Monel. The gas lines that are exposed to only one of the individual vapours is made of electropolished stainless steel. A proper choice is of great importance as the entire purpose of the etch is defeated if the removal of the native oxide would lead to an excessive generation of particles from either the reactor walls, the wafer support structure, the gas feed lines, etc.

The reactor is loaded with a batch comprising 4-25 silicon wafers, being kept at ambient temperature. Subsequently, the reactor chamber loaded with wafers is evacuated. After evacuation, the valve to the pump is closed. After this the inlet of HAc vapour is opened and HAc vapour is injected into the reactor up to a pressure of 600 Pa. Then the HAc inlet is closed. After this, the HF inlet is opened, HF vapour is injected into the reactor up to a total pressure of 900 Pa (partial HF pressure is 300 Pa) and the HF inlet is closed. The wafers are subsequently kept isolated in the system for some time, in this case 200 seconds. After said time interval has elapsed, the pump valve is opened and the process gases are pumped away. Then the reactor is purged with dry $N_2$ to atmospheric pressure.

The results of this procedure were already presented in table 3. In the Tables, etch depth is indicated in Angströms (Å) (1Å equals 0.1 nm).

Although the invention is described referring to a preferred embodiment, other carboxylic acids may be used.

Table 1

| Etching results in HF/$H_2O$ vapour | | | | |
|---|---|---|---|---|
| Wafer | Minimal etch depth (Å) | Maximal etch depth (Å) | Mean etch depth (Å) | Standard deviation |
| 1 | 38 | 150 | 85 | 38 |
| 2 | 26 | 106 | 50 | 32 |

Table 1 (continued)

| Etching results in HF/$H_2O$ vapour | | | | |
|---|---|---|---|---|
| Wafer | Minimal etch depth (Å) | Maximal etch depth (Å) | Mean etch depth (Å) | Standard deviation |
| 3 | 38 | 104 | 61 | 26 |
| 4 | 38 | 113 | 65 | 26 |
| 5 | 18 | 97 | 43 | 37 |
| 6 | 22 | 89 | 45 | 34 |

Table 2

| Surface area occupied by different molecules adsorbed on silicon dioxide | | |
|---|---|---|
| Molecule | Formula | Surface area/molecule |
| | | (Å**2) |
| Acetic Acid | $CH_3COOH$ | 9.1 |
| Water | $H_2O$ | 12.5 |
| Nitrogen | $N_2$ | 16.4 |
| Methanol | $CH_3OH$ | 18.0 |
| Ethanol | $C_2H_5OH$ | 18.0 |
| n-Propanol | $C_3H_7OH$ | 21.3 |
| Hexene | $C_6H_6$ | 55.0 |

Table 3

| Etching results in HF/HAc vapour | | | | |
|---|---|---|---|---|
| Wafer | Minimal etch depth (Å) | Maximal etch depth (Å) | Mean etch depth (Å) | Standard deviation |
| 1 | 71 | 97 | 84 | 5.8 |
| 2 | 75 | 100 | 89 | 7.7 |
| 3 | 72 | 97 | 86 | 6.2 |
| 4 | 71 | 91 | 82 | 4.6 |

Table 4

| Experimental matrix to investigate the HAc/HF parameter space | | | | | |
|---|---|---|---|---|---|
| $P_{HF}$ | $P_{HAc}$ | Etch depth | p-p deviation | w-w deviation | contact angle |
| Pa | Pa | Å | % | % | ° |
| 200 | 200 | 83.5 | 15.9 | 2.4 | 59.8 |
| 400 | 200 | 200.5 | 13.4 | 7.6 | 62.0 |

Table 4 (continued)

| Experimental matrix to investigate the HAc/HF parameter space | | | | | |
|---|---|---|---|---|---|
| $P_{HF}$ | $P_{HAc}$ | Etch depth | p-p deviation | w-w deviation | contact angle |
| Pa | Pa | Å | % | % | ° |
| 200 | 800 | 181.6 | 7.7 | 4.9 | 61.1 |
| 400 | 800 | 395.3 | 6.7 | 1.6 | 62.9 |
| 300 | 500 | 216.1 | 11.6 | 1.7 | 58.1 |
| 300 | 200 | 155.9 | 14.5 | 4.4 | 58.9 |
| 200 | 500 | 148.1 | 12.6 | 1.4 | 58.8 |
| 300 | 800 | 288.7 | 10.2 | 2.6 | 62.8 |
| 400 | 500 | 299.7 | 12.1 | 2.9 | 62.5 |

Table 5

| Etch rate selectivity for TEOS oxide/thermal oxide | | | |
|---|---|---|---|
| Mixture | As-deposited | Half densified | Densified |
| liquid 0.5 vol% HF in H2O | 8.5 | 5.0 | 1.4 |
| vapor, 300 Pa HF,600 Pa HAc | 12.0 | 4.1 | 1.4 |
| As-deposited TEOS oxide | 725 °C, low pressure | | |
| Half densified TEOS oxide | 850 °C for 0.5 h in N2 | | |
| Densified TEOS oxide | 1050 °C for 1 h in N2 | | |

**Claims**

**1.** A method of etching silicon oxide ($SiO_2$) layers on a silicon substrate , comprising the steps of:

loading said silicon substrate in a reactor;
injecting in said reactor a mixture of gases comprising hydrogen fluoride (HF) and at least one carboxylic acid, while keeping the temperature of said substrate at a value between 0°C and below 100°C, while maintaining said mixture in the gas phase, while the partial vapor pressures of HF and the carboxylic acid are being maintained between 1 Pa and $10^4$ Pa and wherein said carboxylic acid acts as a catalyst for the reaction

$$HF + SiO_2 \rightarrow SiF_4 + H_2O.$$

**2.** The method as recited in claim 1 wherein the temperature of said substrate is kept at ambient temperature.

**3.** The method as recited in claim 1 wherein the partial vapor pressures of HF and the carboxylic acid are comprised between 100 Pa and 1000 Pa.

**4.** The method as recited in claim 3 wherein the partial vapor pressure of HF is 300 Pa and the partial vapor pressure of the carboxylic acid is 600 Pa.

**5.** The method as recited in any one of the preceding claims wherein the carboxylic acid is acetic acid.

**6.** The method as recited in any one of the preceding claims wherein said mixture further comprises water vapor or gases such as Ar, $N_2$, and $H_2$.

7. The method as recited in any one of the preceding claims wherein said mixture further comprises HCl or organic solvents such as alcohols, ketones, aldehides and esters.

**Patentansprüche**

1. Verfahren zum Ätzen von Siliziumoxid ($SiO_2$)-Schichten auf einem Siliziumsubstrat, das die Schritte aufweist, bei denen:

   das Siliziumsubstrat in eine Reaktionskammer eingebracht wird;
   in die Reaktionskammer ein Gemisch von Gasen eingeblasen wird, das Fluorwasserstoff (HF) und mindestens eine Karbonsäure aufweist, während die Temperatur des Substrats auf einem Wert zwischen O□C und unter 100□C gehalten wird, während das Gemisch in der Gasphase gehalten wird, während die Partialdampfdrücke von HF und der Karbonsäure zwischen 1 Pa und $10^4$ Pa gehalten werden, und wobei die Karbonsäure als ein Katalysator für die Reaktion

   $$HF + SiO_2 \rightarrow SiF_4 + H_2O$$

   wirkt.

2. Verfahren wie in Anspruch 1 angegeben, wobei die Temperatur des Substrats auf Umgebungstemperatur gehalten wird.

3. Verfahren wie in Anspruch 1 angegeben, wobei die Partialdampfdrücke von HF und der Karbonsäure zwischen 100 Pa und 1000 Pa liegen.

4. Verfahren wie in Anspruch 3 angegeben, wobei der Partialdampfdruck von HF 300 Pa beträgt, und der Partialdampfdruck der Karbonsäure 600 Pa beträgt.

5. Verfahren wie in irgendeinem der vorhergehenden Ansprüche angegeben, wobei die Karbonsäure Essigsäure ist.

6. Verfahren wie in irgendeinem der vorhergehenden Ansprüche angegeben, wobei das Gemisch weiterhin Wasserdampf oder Gase, wie Ar, $N_2$ und $H_2$ aufweist.

7. Verfahren wie in irgendeinem der vorhergehenden Ansprüche angegeben, wobei das Gemisch weiterhin HCl oder organische Lösungsmittel, wie Alkohole, Ketone, Aldehyde und Ester aufweist.

**Revendications**

1. Procédé de gravure de couches d'oxyde de silicium ($SiO_2$) sur un substrat de silicium, comprenant les étapes consistant à :

   - charger ledit substrat de silicium dans un réacteur,
   - injecter dans ledit réacteur un mélange de gaz comprenant du fluorure d'hydrogène (HF) et au moins un acide carboxylique, tout en maintenant la température dudit substrat à une valeur comprise entre 0°C et moins de 100°C et en maintenant ledit mélange en phase gazeuse, tandis que les pressions de vapeur partielles du HF et de l'acide carboxylique sont maintenues entre 1 Pa et $10^4$ Pa, et dans lequel ledit acide carboxylique joue le rôle d'un catalyseur pour la réaction

   $$HF + SiO_2 \rightarrow SiF_4 + H_2O.$$

2. Procédé selon la revendication 1, dans lequel la température dudit substrat est maintenue à température ambiante.

3. Procédé selon la revendication 1, dans lequel les pressions de vapeur partielles du HF et de l'acide carboxylique sont comprises entre 100 Fa et 1000 Pa.

4. Procédé selon la revendication 3, dans lequel la pression de vapeur partielle du HF est de 300 Pa et la pression de vapeur partielle de l'acide carboxylique est de 600 Pa.

5. Procédé selon l'une quelconque des revendications précédentes, dans lequel l'acide carboxylique est l'acide acétique.

6. Procédé selon l'une quelconque des revendications précédentes, dans lequel ledit mélange comprend par ailleurs de la vapeur d'eau ou des gaz tels que Ar, $N_2$ et $H_2$.

7. Procédé selon l'une quelconque des revendications précédentes, dans lequel ledit mélange comprend par ailleurs du HCl ou des solvants organiques, tels que des alcools, des cétones, des aldéhydes et des esters.

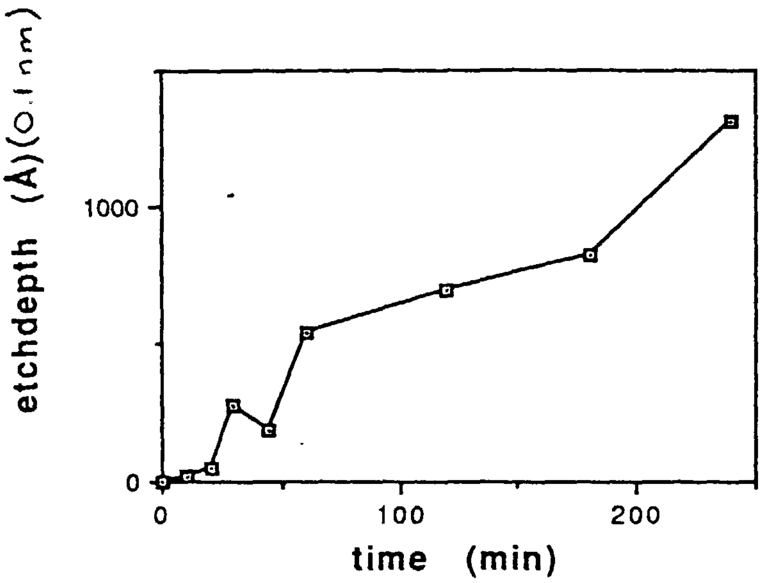


Fig. 1 Etch depth as a function of etching time in $HF/H_2O$ vapor.

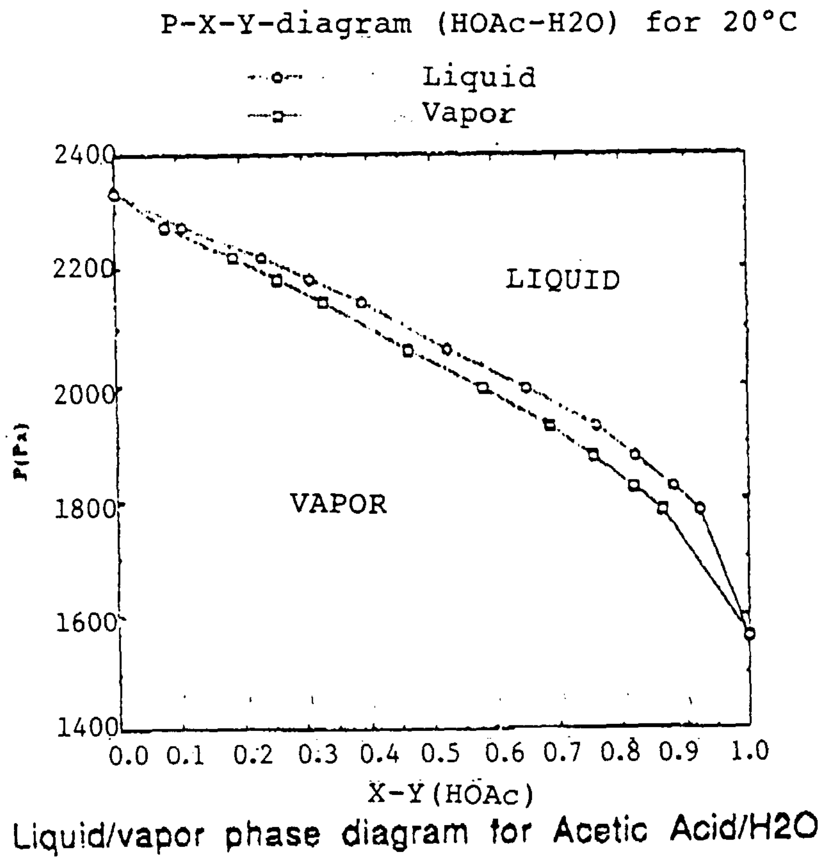


Liquid/vapor phase diagram for Acetic Acid/H2O mixtures.

FIG. 2.

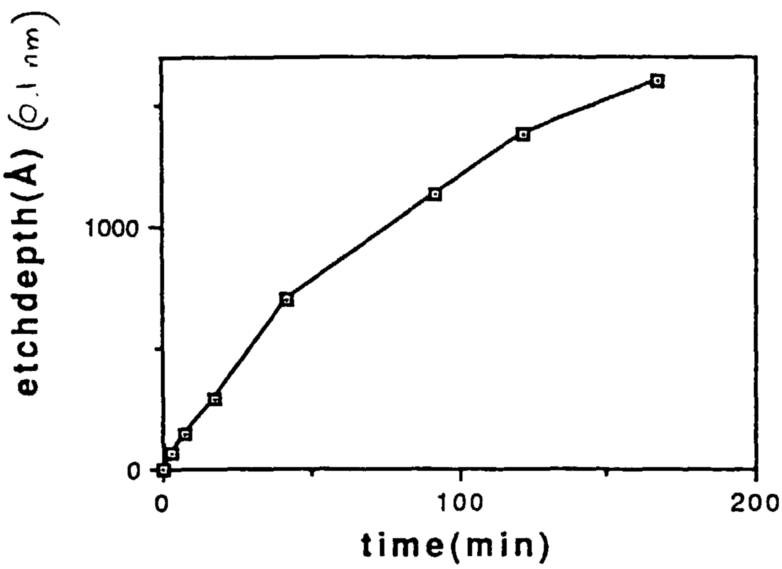


Fig. 3 Time evolution of etch depth for a HF/Acetic acid vapor mixture

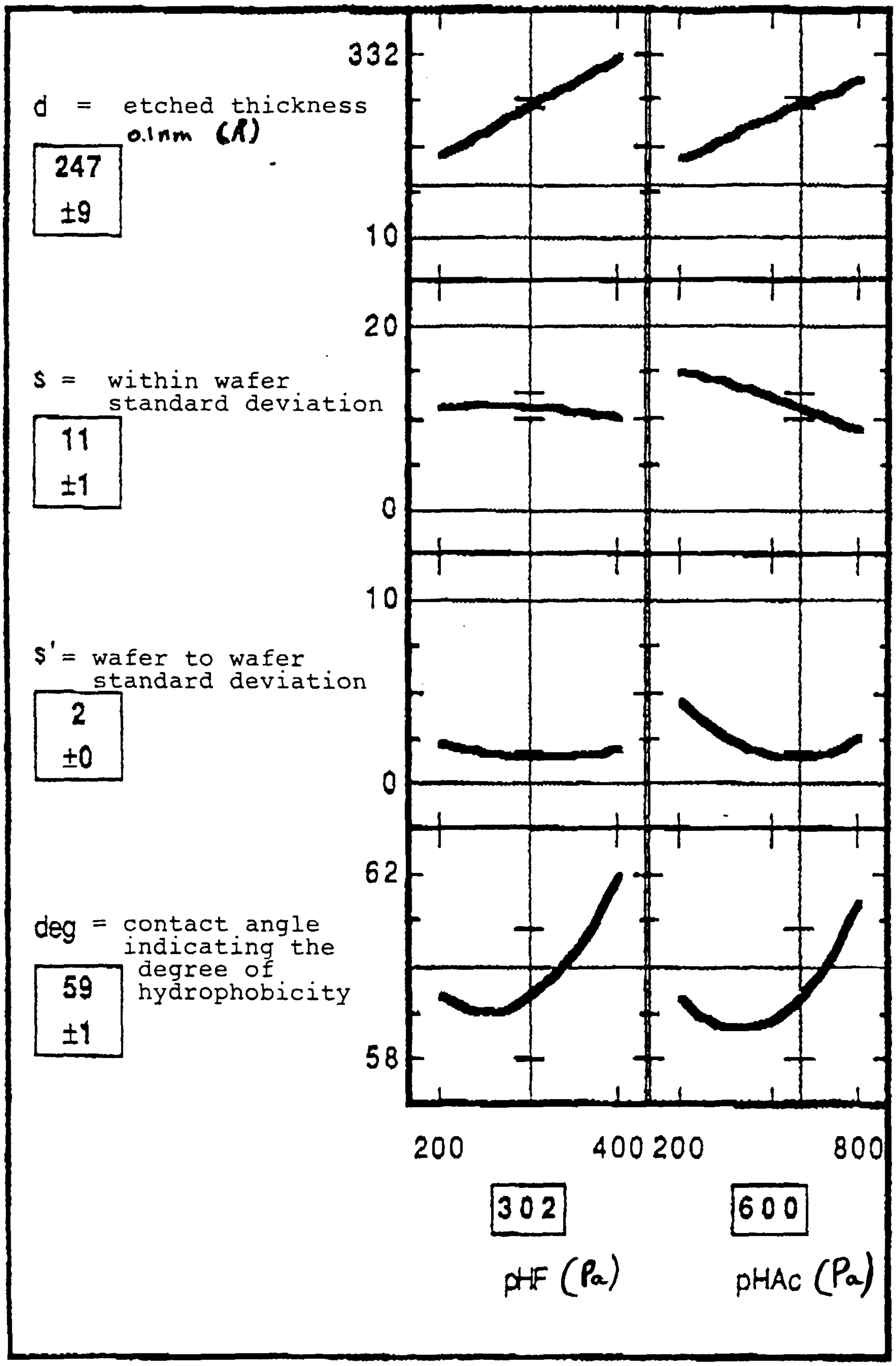
d = etched thickness
0.1nm (Å)
247
±9
332
10
20
$ = within wafer standard deviation
11
±1
0
10
$' = wafer to wafer standard deviation
2
±0
0
62
deg = contact angle indicating the degree of hydrophobicity
59
±1
58
200
400
200
800
302
600
pHF (Pa)
pHAc (Pa)

Fig. 4